# EUROPEAN PATENT SPECIFICATION

(11) **EP 4 585 454 B1**
(45) Date of publication and mention of the grant of the patent: **09.12.2026**
(21) Application number: 23883054.1
(22) Date of filing: 24.10.2023
(51) Int. Cl.: B60L 58/10, B60K 35/00, H02J 7/00, H01M 10/48, H01M 10/42, G01R 31/392, B60K 35/28, G01R 31/382, G01C 21/34, G01R 31/367, G01R 31/36, B60W 50/14, B60L 58/16, B60L 58/12, B60L 3/12, B60L 3/00, B60K 35/22

(54) **DEVICE FOR CALCULATING BATTERY EFFICIENCY OF ELECTRIC VEHICLE AND OPERATION METHOD THEREOF**
VORRICHTUNG ZUR BERECHNUNG DER BATTERIEEFFIZIENZ EINES ELEKTROFAHRZEUGS UND BETRIEBSVERFAHREN DAFÜR
DISPOSITIF DE CALCUL D'EFFICACITÉ DE BATTERIE DE VÉHICULE ÉLECTRIQUE ET SON PROCÉDÉ DE FONCTIONNEMENT

(30) Priority: 27.10.2022 KR 20220140760
(43) Date of publication of application: 16.07.2025
(73) Proprietor: LG Energy Solution, Ltd., Seoul 07335 (KR)
(72) Inventor: JUNG, Boo Soon, Daejeon 34122 (KR); KIM, Joo Sung, Daejeon 34122 (KR); CHOI, Yo Hwan, Daejeon 34122 (KR); CHOI, Min Sook, Daejeon 34122 (KR)
(74) Representative: Goddar, Heinz J.
(86) International application number: PCT/KR2023/016549
(87) International publication number: WO 2024/090948

(56) References cited:
- JP-A- 2013 090 360
- JP-A- 2014 096 928
- KR-A- 20200 075 118
- KR-A- 20210 155 030
- US-A1- 2014 095 060
- US-A1- 2018 080 995
- US-A1- 2018 080 995
- US-A1- 2020 376 927
- US-A1- 2021 184 273
- US-A1- 2021 339 650

## Description

### [TECHNICAL FIELD]

### CROSS-REFERENCE TO RELATED APPLICATION

This application claims priority to and the benefit of Korean Patent Application No. 10-2022-0140760 filed in the Korean Intellectual Property Office on October 27, 2022.

### TECHNICAL FIELD

Embodiments disclosed herein relate to an apparatus for calculating the efficiency of a battery of an electric vehicle and a method of operating the same.

### [BACKGROUND ART]

As environmental problems and energy resource problems emerge, hybrid electric vehicles and electric vehicles among various types of vehicles are receiving attention as a future transportation means. The hybrid electric vehicles and the electric vehicles may use a battery pack including a plurality of secondary batteries capable of charging and discharging as a main power source.

Batteries gradually deteriorate over time due to charging, discharging, and leaving unattended from a time point of shipment. The battery deterioration appears in various forms, such as a decrease in maximum chargeable capacity and an increase in internal resistance, and there are parameters that may check a degree of deterioration of each of a plurality of battery cells connected in series in a battery pack.

In addition, the battery has an available capacitor that may be changed depending on a surround environment (e.g., weather).

US 2021/184273 A1 discloses: Discussed is an application that efficiently utilizes a vehicle battery by predicting performance of the vehicle battery and an available driving distance based on environmental condition of an area where a vehicle is parked and state information of the vehicle battery.

US 2018/080995 A1 discloses a notification method and system for providing notification regarding remaining time of a battery. According to certain embodiments, the method may include predicting an ambient temperature of the battery. The method may also include determining a power demand for the battery. The method may also include determining a state of health (SoH) of the battery. The method may also include predicting a remaining time for a state of charge (SoC) of the battery to reach a predetermined level, based on the ambient temperature, the power demand, and the SoH. The method may further include providing a notification regarding the remaining time.

US 2021/339650 A1 discloses that in a vehicle power supply system mounted on an electric vehicle, a vehicle controller switches a discharge power limit to a motor during travel of the electric vehicle according to degradation information of a battery module to which a plurality of cells are connected, the degradation information being calculated in advance before the travel of the electric vehicle. For example, the vehicle controller switches a limit of a maximum acceleration and/or maximum speed of the electric vehicle as the switching of the discharge power limit.

US 2020/376927 A1 discloses: A computer-implemented method for managing thermal qualities of a vehicle. The method comprises determining one or more factors associated with a trip to be taken by a vehicle. The method comprises estimating future thermal load based on the determined factors for one or more components of the vehicle. The method comprises generating an optimal thermal management plan based on the estimated future thermal load for the one or more components. The method comprises performing thermal management of the one or more components based on the optimal thermal management plan.

US 2014/095060 A1 discloses: a system and method for computing distance to empty (DTE) based on available energy computed using a battery SOC vs open circuit voltage (OCV) table, battery temperature vs energy efficiency, an energy efficiency vs energy table, etc., to enable a more accurate calculation of the DTE in consideration of the temperature of the battery, which is one of disturbance elements.

### [TECHNICAL PROBLEM]

As an available capacitor of a battery is changed depending on a surrounding environment (e.g., weather), a distance to empty of an electric vehicle may also be changed.

Therefore, a method for increasing prediction possibility for the distance to empty of the user is required.

The objects of embodiments disclosed herein are not limited to the above-described objects, and other objects that are not mentioned will be able to be clearly understood by those skilled in the art from the following descriptions.

### [TECHNICAL SOLUTION]

The invention is set out in the appended claims. An apparatus for calculating the efficiency of a battery according to one embodiment disclosed herein includes a data collection unit configured to collect usage data on an electric vehicle, a weather data acquisition unit configured to acquire weather forecast data from an external server, and a calculation unit configured to calculate efficiency of a battery of the electric vehicle based on the usage data and the weather forecast data.

The apparatus for calculating the efficiency of the battery according to one embodiment disclosed herein further includes a pattern analysis unit configured to analyze a usage pattern of the electric vehicle based on the usage data, and a prediction unit configured to predict a next usage time of the electric vehicle based on the usage pattern, wherein the calculation unit calculates the efficiency of the battery based on the next usage time and the weather forecast data.

The prediction unit of the apparatus for calculating the efficiency of the battery according to one embodiment disclosed herein may predict a next traveling route of the electric vehicle based on the usage pattern, and the calculation unit may calculate the efficiency of the battery further based on the traveling route.

The apparatus for calculating the efficiency of the battery according to one embodiment disclosed herein may further include a display unit configured to display the calculated efficiency.

The calculation unit of the apparatus for calculating the efficiency of the battery determines a relationship expression based on a battery efficiency database for the battery and calculate the efficiency of the battery based on the relationship expression.

In the apparatus for calculating the efficiency of the battery according to one embodiment disclosed herein, the relationship expression may be a polynomial function with the highest order of 2 for a temperature.

the calculation unit of the apparatus for calculating the efficiency of the battery according to one embodiment disclosed herein may calculate the efficiency of the battery using the relationship expression in a predetermined temperature range.

The calculation unit of the apparatus for calculating the efficiency of the battery according to one embodiment disclosed herein may determine the relationship expression based on a state of health (SoH) of the battery.

The calculation unit of the apparatus for calculating the efficiency of the battery according to one embodiment disclosed herein may calculate a distance to empty of the electric vehicle based on a SoH of the battery and the efficiency of the battery.

The apparatus for calculating the efficiency of the battery according to one embodiment disclosed herein may further include a discharge rate analysis unit configured to analyze a discharge rate of the battery of the electric vehicle based on the usage data, wherein the calculation unit calculates a travelable time of the electric vehicle based on the discharge rate and the efficiency of the battery.

A method of operating an apparatus of calculating the efficiency of a battery according to one embodiment disclosed herein includes an operation of collecting usage data on an electric vehicle, an operation of acquiring weather forecast data from an external server, and an operation of calculating efficiency of a battery of the electric vehicle based on the usage data and the weather forecast data.

The method of operating the apparatus of calculating the efficiency of the battery according to one embodiment disclosed herein may further include an operation of analyzing a usage pattern of the electric vehicle based on the usage data, and an operation of predicting a next usage time of the electric vehicle based on the usage pattern, wherein the operation of calculating the efficiency of the battery includes an operation of calculating the efficiency of the battery based on the next usage time and the weather forecast data.

The method of operating the apparatus of calculating the efficiency of the battery according to one embodiment disclosed herein may further include an operation of predicting a next traveling route of the electric vehicle based on the usage pattern, wherein the operation of calculating the efficiency of the battery includes calculating the efficiency of the battery further based on the traveling route.

The method of operating the apparatus of calculating the efficiency of the battery according to one embodiment disclosed herein may further include an operation of displaying the calculated efficiency.

The operation of calculating the efficiency of the battery of the method of operating the apparatus of calculating the efficiency of the battery according to one embodiment disclosed herein may further include an operation of determining a relationship expression based on a battery efficiency database for the battery, and an operation of calculating the efficiency of the battery based on the relationship expression.

In the method of operating the apparatus of calculating the efficiency of the battery according to one embodiment disclosed herein, the relationship expression may be a polynomial function with the highest order of 2 for a temperature.

The operation of calculating the efficiency of the battery of the method of operating the apparatus of calculating the efficiency of the battery according to one embodiment disclosed herein may further include an operation of calculating the efficiency of the battery using the relationship expression in a predetermined temperature range.

The operation of determining the relationship expression of the method of operating the apparatus of calculating the efficiency of the battery according to one embodiment disclosed herein may further include an operation determining the relationship expression based on a state of health (SoH) of the battery.

The operation of calculating the efficiency of the battery of the method of operating the apparatus of calculating the efficiency of the battery according to one embodiment disclosed herein may further include an operation of calculating a distance to empty of the electric vehicle based on a SoH of the battery and the efficiency of the battery.

The method of operating the apparatus of calculating the efficiency of the battery according to one embodiment disclosed herein may further include an operation of analyzing a discharge rate of the battery of the electric vehicle based on the usage data, wherein the operation of calculating the efficiency of the battery further includes an operation of calculating a travelable time of the electric vehicle based on the discharge rate and the efficiency of the battery.

### [ADVANTAGEOUS EFFECTS]

According to the apparatus for calculating the efficiency of the battery and the method of operating the same according to various embodiments disclosed herein, it is possible to calculate the efficiency of the battery.

According to the apparatus for calculating the efficiency of the battery and the method of operating the same according to various embodiments disclosed herein, it is possible to provide the calculated efficiency of the battery of the electric vehicle to the user.

According to the apparatus for calculating the efficiency of the battery and the method of operating the same according to various embodiments disclosed herein, it is possible to provide the distance to empty of the electric vehicle according to the calculated efficiency of the battery of the electric vehicle to the user.

The effects of the apparatus for calculating the efficiency of the battery and the method of operating the same according to the disclosure of the present document are not limited to the above-described effects, and other effects that are not mentioned will be able to be clearly understood by those skilled in the art according to the disclosure of the present document.

### [DESCRIPTION OF DRAWINGS]

FIG. 1 is a block diagram of an apparatus for calculating the efficiency of a battery according to various embodiments of the present disclosure.
FIG. 2A illustrates a reference material for generating an efficiency database.
FIG. 2B illustrates a reference material for generating the efficiency database.
FIG. 2C illustrates a reference material for generating the efficiency database.
FIG. 3 illustrates a relationship expression generated by the apparatus for calculating the efficiency of the battery according to one embodiment of the present disclosure based on the efficiency database.
FIG. 4Aillustrates a user interface (UI) displayed by the apparatus for calculating the efficiency of the battery according to one embodiment of the present disclosure.
FIG. 4B illustrates a UI displayed by the apparatus for calculating the efficiency of the battery according to one embodiment of the present disclosure.
FIG. 5 is a flowchart illustrating a method of operating the apparatus for calculating the efficiency of the battery according to one embodiment of the present disclosure.

In the description of the drawings, the same or similar reference numerals may be used for the same or similar components.

### [MODE FOR INVENTION]

Hereinafter, embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items, unless the relevant context clearly dictates otherwise.

In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," "second," "A," "B," "(a)," or "(b)" may simply be used to distinguish the corresponding component from another and do not limit the corresponding components in another aspect (e.g., importance or order).

When a certain component (e.g., a first component) is described as being "coupled," "connected," or "joined" to another component (e.g., a second component) with or without the terms "functionally" or "communicatively" or "coupled" or "connected," this means that the certain component may be connected to another component directly (e.g., by wire or wirelessly) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through an application store or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

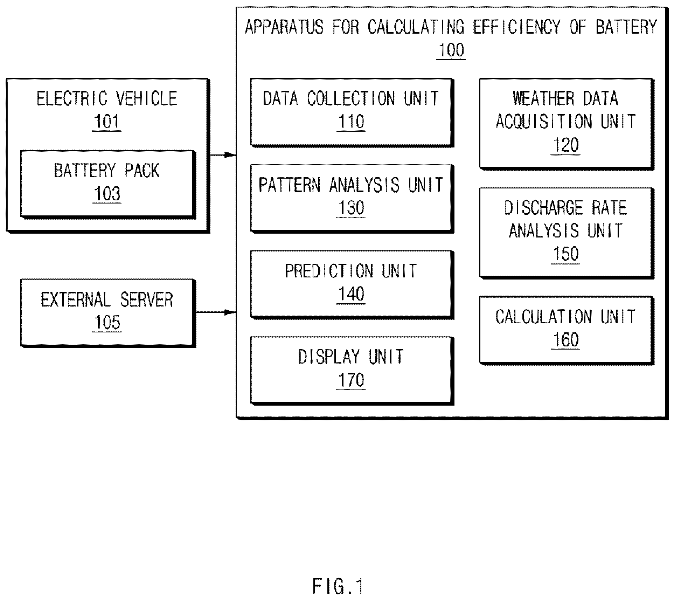

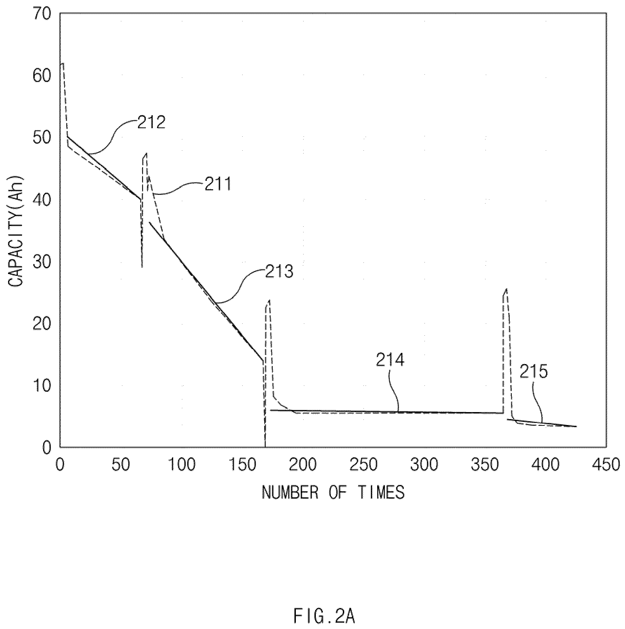

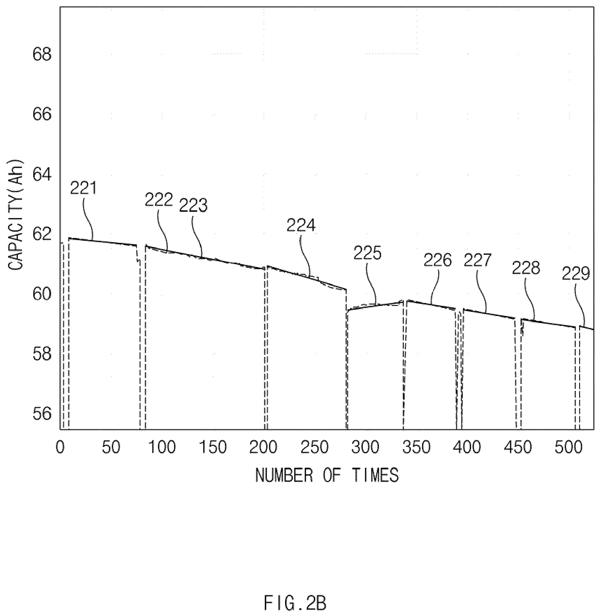

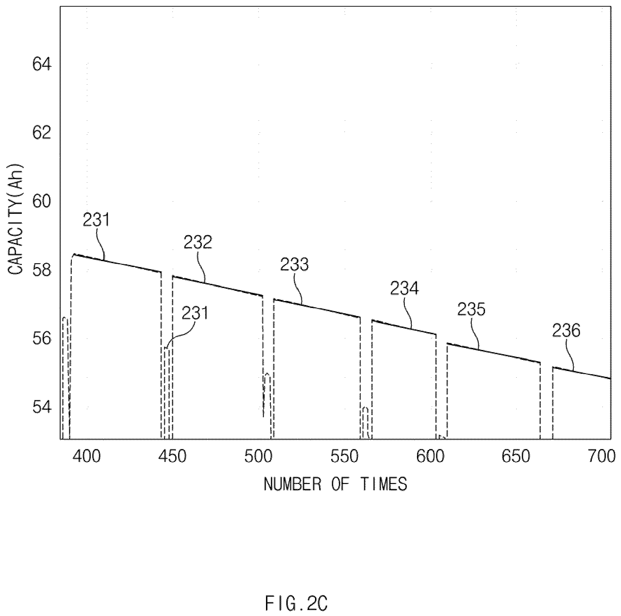

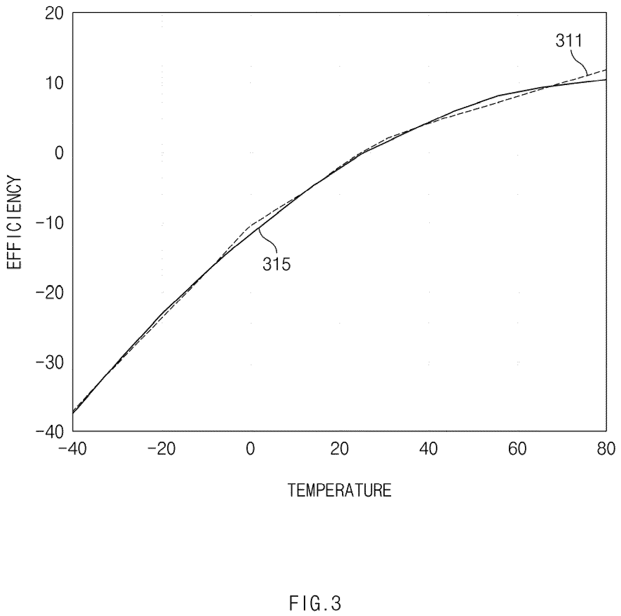

FIG. 1 is a block diagram of an apparatus 100 for calculating the efficiency of a battery according to various embodiments of the present disclosure. FIG. 2A illustrates a reference material for generating an efficiency database. FIG. 2B illustrates a reference material for generating the efficiency database. FIG. 2C illustrates a reference material for generating the efficiency database. FIG. 3 illustrates a relationship expression generated by the apparatus 100 for calculating the efficiency of the battery according to one embodiment of the present disclosure based on the efficiency database.

In one embodiment, the apparatus 100 for calculating the efficiency of the battery may be formed integrally with an electric vehicle 101. In another embodiment, the apparatus 100 for calculating the efficiency of the battery may be formed separately from the electric vehicle 101. For example, the apparatus 100 for calculating the efficiency of the battery may be implemented as a portable terminal (e.g. a smartphone). As another example, the apparatus 100 for calculating the efficiency of the battery may be a service provision server. When the apparatus 100 for calculating the efficiency of the battery is implemented as the service provision server, the apparatus 100 for calculating the efficiency of the battery may provide information about the efficiency of a battery pack 103 of the electric vehicle 101 to a terminal interlocked to the user of the electric vehicle 101.

Referring to FIG. 1, the apparatus 100 for calculating the efficiency of the battery may include a data collection unit 110, a weather data acquisition unit 120, a pattern analysis unit 130, a prediction unit 140, a discharge rate analysis unit 150, a calculation unit 160, and a display unit 170.

In one embodiment, the data collection unit 110 may be implemented as a communication circuit. In this case, the data collection unit 110 may transmit and receive data to and from the electric vehicle 101 by wire and/or wirelessly.

In one embodiment, the data collection unit 110 may collect usage data on the electric vehicle 101. In one embodiment, the usage data may include position information, traveling information (a traveling time or a traveling route), fuel efficiency during traveling, and information about a discharge rate (or a C-rate) of the battery pack 103 of the electric vehicle 101.

In one embodiment, the pattern analysis unit 130 may be implemented as a processor capable of performing various data processing or calculation. In one embodiment, the pattern analysis unit 130 may analyze a usage pattern of the electric vehicle 101 based on the usage data of the data collection unit 110. In one embodiment, the pattern analysis unit 130 may analyze information about the usage pattern by time and date of the electric vehicle 101 based on the usage data. For example, the pattern analysis unit 130 may classify whether the electric vehicle 101 is used for each time section (e.g., in units of 15 minutes or 30 minutes) and a traveling section when the electric vehicle 101 is used based on the position information and the traveling information (the traveling time and the traveling route). In one embodiment, the pattern analysis unit 130 may determine a usage pattern by time period based on classified data. In one embodiment, the usage pattern may include information about a traveling route, a traveling time, and fuel efficiency.

In one embodiment, the prediction unit 140 may be implemented as a processor capable of performing various data processing or calculation. In one embodiment, the prediction unit 140 may predict the next usage time of the electric vehicle 101 based on the usage pattern. In one embodiment, the next usage time may be determined probabilistically based on the usage pattern. For example, the prediction unit 140 may determine that a first time point at which a usage probability by time section (e.g., in units of 15 minutes or 30 minutes) exceeds a threshold is the next usage time.

In one embodiment, the prediction unit 140 may predict the next traveling route of the electric vehicle 101 based on the usage pattern. In one embodiment, the next traveling route may be the most used traveling route in the determined next usage time.

In one embodiment, the weather data acquisition unit 120 may be implemented as a communication circuit. In this case, the weather data acquisition unit 120 may transmit and receive data to and from an external server 105 wirelessly.

In one embodiment, the weather data acquisition unit 120 may acquire weather forecast data from the external server 105. In one embodiment, the weather forecast data may include information about weather by time (e.g., temperature, rainfall, snowfall, or wind speed) and information on regional weather.

In one embodiment, the weather data acquisition unit 120 may acquire weather information about areas within a predetermined distance (e.g., 300 km) from an area in which the electric vehicle 101 is positioned from the external server 105. In one embodiment, the weather data acquisition unit 120 may acquire weather information about visitable areas according to the traveling pattern of the electric vehicle 101 from the external server 105. In one embodiment, the visitable areas may be areas in which the electric vehicle 101 visited within a predetermined time period (e.g., 2 weeks). Here, the visitable areas may be set differently by weekday, weekend, and public holiday. In this case, a predetermined time period (e.g., 2 weeks, 1 month, or 6 months) by weekday, weekend, and public holiday may be set differently.

In one embodiment, the discharge rate analysis unit 150 may be implemented as a processor capable of performing various data processing or calculation. In one embodiment, the discharge rate analysis unit 150 may analyze a discharge rate of the battery pack 103 of the electric vehicle 101 based on the usage data. In one embodiment, the discharge rate analysis unit 150 may determine the discharge rate for each predetermined time period. For example, the discharge rate analysis unit 150 may determine an average value of discharge rates by quarter based on the usage data.

In one embodiment, the calculation unit 160 may calculate the efficiency of the battery pack 103 of the electric vehicle 101 based on weather forecast data. Here, the efficiency may represent a rate of change in available capacity that varies depending on temperature.

In one embodiment, the calculation unit 160 may determine a relationship expression based on the battery efficiency database for the battery pack 103. In one embodiment, the calculation unit 160 may calculate the efficiency of the battery pack 103 based on the determined relationship expression. Here, the relationship expression may be a polynomial function with the highest order of 2 for temperature. Here, the relationship expression may be determined based on a state of health (SoH) of the battery pack 103. For example, the calculation unit 160 may determine a relationship expression corresponding to the SoH of the battery pack 103 among the relationship expressions for each SoH.

In one embodiment, the battery efficiency database may be generated based on experimental data of battery packs of the same type as the battery pack 103. For example, the battery efficiency database may be generated based on information about capacities of battery packs acquired while the battery packs are discharged (e.g., a depth of discharge (DoD) is discharged from 0% to 100%) by temperature.

The battery efficiency database may be generated based on information about the number of capacity-discharge times in a section in which the SoH of the battery pack is a predetermined reference (e.g., 80%) or more. For example, when a state of charge (SoC) is 100% at a time point at which the SoH of the battery pack is 100%, the capacity of the battery pack may be 60 Ah. In this case, the battery efficiency database may be generated based on the information about the number of capacity-discharge times with a capacity of 48 Ah or more when the battery pack is fully charged (the SoC is 100%).

FIG. 2A illustrates a graph of the number of capacity-discharge times acquired while the DoD of the battery pack is discharged from 0% to 100% at -10 °C. Referring to FIG. 2A, measured data 211 may represent a measured value of the capacity of the battery pack according to the number of discharges, and fitted data 212, 213, 214, and 215 may represent a change in average for each section of the measured data 211. Sections of the measured data 211 may be divided by points (hereinafter referred to as change points) at which the measured value is changed rapidly. The battery efficiency database may be generated based on data 212 in which the SoH of the battery pack is the predetermined reference (80%) or more among the fitted data 212, 213, 214, and 215. For example, the battery efficiency database may be generated based on a ratio (or a percentage) of an available capacity to a real capacity acquired from the data 212 in which the SoH of the battery pack is the predetermined reference (80%) or more. For example, when the DoD of the battery pack is discharged from 0% to 100%, the available capacity of the battery pack at -10 °C may be 83% of the real capacity.

FIG. 2B illustrates a graph of the number of capacity-discharge times acquired while the DoD of the battery pack is discharged from 0% to 100% at 25 °C. Referring to FIG. 2B, measured data 221 may represent a measured value of the capacity of the battery pack according to the number of discharges, and fitted data 222 to 229 may represent a change in average for each section of the measured data 221. The battery efficiency database may be generated based on data 222 to 2 in which the SoH of the battery pack is the predetermined reference (80%) or more among the fitted data 222 to 229. For example, when the DoD of the battery pack is discharged from 0% to 100%, the available capacity of the battery pack at 25 °C may be 100% of the real capacity.

FIG. 2C illustrates a graph of the number of capacity-discharge times acquired while the DoD of the battery pack is discharged from 0% to 100% at 45 °C. Referring to FIG. 2C, measured data 231 may represent a measured value of the capacity of the battery pack according to the number of discharges, and fitted data 232 to 236 may represent a change in average for each section of the measured data 231. The battery efficiency database may be generated based on the data 232 to 236 in which the SoH of the battery pack is the predetermined reference (80%) or more among the fitted data 232 to 236. For example, when the DoD of the battery pack is discharged from 0% to 100%, the available capacity of the battery pack at 45 °C may be 103% of the real capacity.

In one embodiment, the battery efficiency database may be expressed as in Table 1 below.

**[Table 1]**

| DoD | temperature | | | | | | |
|---|---|---|---|---|---|---|---|
| | -10 | 0 | 10 | 25 | 35 | 45 | 55 |
| 100 | 83% | 89% | 94% | 100% | 102% | 103% | 105% |

Referring to Table 1, the battery efficiency database may include information about efficiency according to the temperature of the battery pack when the DoD of the battery pack is discharged from 0% to 100%.

According to the embodiments, the battery efficiency database may include information about efficiency according to the temperature of the battery pack acquired under not only conditions in which the DoD of the battery pack is discharged from 0% to 100%, but also other conditions (e.g. from 30% to 80%, from 0% to 80%, or from 30% to 100%).

According to the embodiments, the battery efficiency database may include information about efficiency according to the temperature of the battery pack acquired according to different SoHs of the battery pack. For example, the battery efficiency database may further include information about efficiency according to the temperature of the battery pack acquired when the SoH of the battery pack is 100%, information about efficiency according to the temperature of the battery pack acquired when the SoH is 95%, information about efficiency according to the temperature of the battery pack acquired when the SoH is 90%, and the like.

In one embodiment, the relationship expression may be a polynomial function with the highest order of 2 generated based on the information about the efficiency by temperature of the battery efficiency database as expressed in Table 1. Referring to FIG. 3, a graph 311 based on the fitted data of the battery efficiency database may be changed into a graph 315 according to the polynomial function with the highest order of 2 by the relationship expression.

For example, the relationship expression may be expressed as in Equation 1 below. [Equation 1] ${Q}_{ratio} = {aT}^{2} + bT + c$

Here, a relationship expression Qᵣₐₜᵢₒ may be expressed as the polynomial function with the highest order of 2, and the coefficients a, b, and c may be determined based on the battery efficiency database as in Table 1. Here, T denotes a temperature. For example, a may be -3.11*10⁻³, b may be 5.217*10⁻¹, and c may be -1.156* 10.

In one embodiment, the calculation unit 160 may determine a relationship expression based on the battery efficiency database for the battery pack 103. For example, the calculation unit 160 may select a relationship expression corresponding to a current SoH of the battery pack 103 among the relationship expressions.

In one embodiment, the calculation unit 160 may calculate the efficiency of the battery pack 103 using determined relationship expression in a predetermined temperature range. Here, the predetermined temperature range may be in a range of -40 to 80 °C.

In one embodiment, the calculation unit 160 may calculate the efficiency of the battery pack 103 of the electric vehicle 101 based on the usage data and the weather forecast data. For example, the calculation unit 160 may calculate the efficiency of the battery pack 103 based on the next usage time and weather forecast data. The calculation unit 160 may determine a temperature of the next usage time and calculate efficiency of the battery pack 103 based on the determined temperature. For another example, the calculation unit 160 may determine temperatures of areas passing through along the next traveling route and calculate efficiency of the battery pack 103 based on the determined temperature.

In one embodiment, the calculation unit 160 may calculate a distance to empty of the electric vehicle 101 based on the SoH of the battery pack 103 and the efficiency of the battery pack 103. For example, the calculation unit 160 may identify a capacity according to the SoH of the battery pack 103 and determine a real available capacity based on the SoC and the efficiency. Thereafter, the calculation unit 160 may calculate the distance to empty of the electric vehicle 101 by multiplying the available capacity by fuel efficiency.

In one embodiment, the calculation unit 160 may calculate the distance to empty of the electric vehicle 101 based on the next usage time and the weather forecast data. For example, the calculation unit 160 may calculate the distance to empty of the electric vehicle 101 by multiplying the real available capacity by the fuel efficiency according to a temperature of the next usage time.

In one embodiment, the calculation unit 160 may calculate the distance to empty of the electric vehicle 101 based on the next traveling route and the weather forecast data. For example, the calculation unit 160 may calculate the distance to empty of the electric vehicle 101 by multiplying the real available capacity by the fuel efficiency according to the temperatures of the areas passing through along the next traveling route.

In one embodiment, the calculation unit 160 may calculate a travelable time of the electric vehicle 101 based on the discharge rate and the efficiency of the battery pack 103. For example, the calculation unit 160 may identify a capacity according to the SoH of the battery pack 103 and determine the real available capacity based on the SoC and the efficiency. Thereafter, the calculation unit 160 may calculate the travelable time of the electric vehicle 101 by multiplying the real available capacity by the discharge rate.

In one embodiment, the calculation unit 160 may calculate the travelable time of the electric vehicle 101 based on the discharge rate and the next traveling route. For example, the calculation unit 160 may calculate the travelable time of the electric vehicle 101 by multiplying the real available capacity by the discharge rate according to the areas passing through along the next traveling route.

In one embodiment, the display unit 170 may be implemented as a display. In this case, the display unit 170 may visually provide information to the outside (e.g., the user) of the apparatus 100 for calculating the efficiency of the battery. In one embodiment, the display unit 170 is implemented as any one of a liquid crystal display (LCD), a light-emitting diode (LED) display, or an organic light-emitting diode (OLED) display. In one embodiment, the display unit 170 may be formed of a touch screen for detecting a touch and/or proximity touch (or hovering) input using a portion (e.g., a finger) of the user's body or an input unit (e.g., a stylus pen). In one embodiment, the display unit 170 may include a touch sensor set to detect a touch or a pressure sensor set to measure an intensity of a force generated by the touch.

In one embodiment, the display unit 170 may display the calculated efficiency. In one embodiment, the display unit 170 may display the calculated distance to empty. In one embodiment, the display unit 170 may display the calculated travelable time.

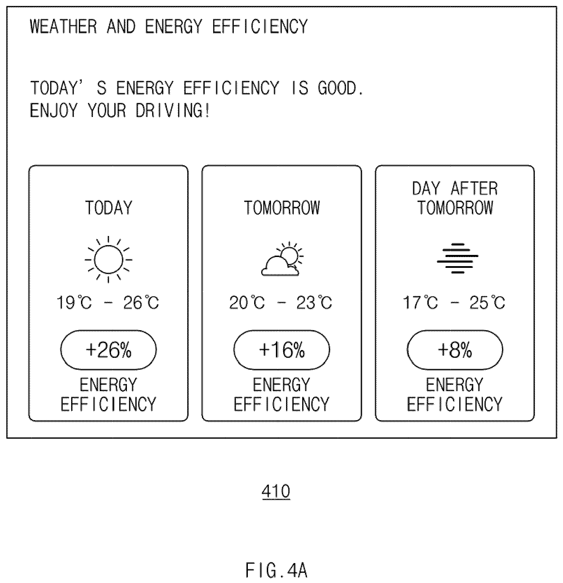

FIG. 4A illustrates a user interface (UI) 410 displayed by the apparatus for calculating the efficiency of the battery according to one embodiment of the present disclosure.

Referring to FIG. 4A, today's efficiency (e.g., 26%) and efficiencies for tomorrow and the day after tomorrow may be displayed on the UI 410. The efficiencies displayed on the UI 410 may be efficiencies calculated according to temperature. In one embodiment, the efficiencies displayed on the UI 410 are efficiencies representative temperatures (e.g., a temperature at noon or a temperature at an expected traveling time) for the corresponding dates.

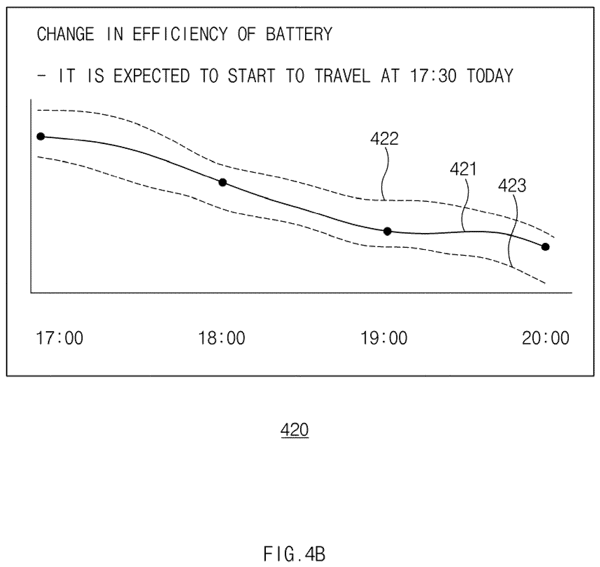

FIG. 4B illustrates a UI 420 displayed by the apparatus for calculating the efficiency of the battery according to one embodiment of the present disclosure.

Referring to FIG. 4B, the UI 420 may display graphs 421, 422, and 423 indicating a change in efficiency when during traveling at 17:30. The graph 421 in the UI 420 may represent real efficiency. The graphs 422 and 423 in the UI 420 may be upper and lower limits of expected efficiency. For example, the upper and lower limits of efficiency may be determined based on upper and lower limits of the temperature.

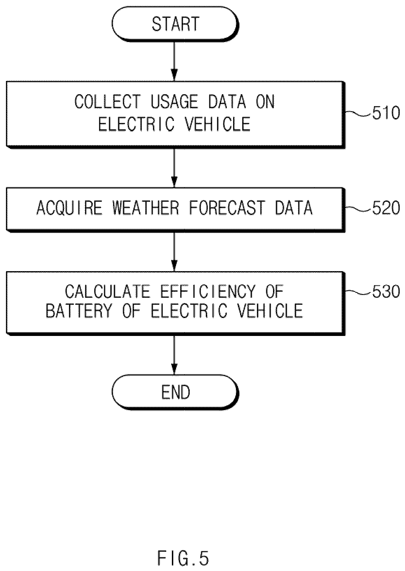

FIG. 5 is a flowchart illustrating a method of operating the apparatus 100 for calculating the efficiency of the battery according to one embodiment of the present disclosure.

Referring to FIG. 5, in operation 510, the apparatus 100 for calculating the efficiency of the battery may collect the usage data on the electric vehicle 101. In one embodiment, the usage data may include position information, traveling information (a traveling time or a traveling route), fuel efficiency during traveling, and information about a discharge rate (or a C-rate) of the battery pack 103 of the electric vehicle 101.

In operation 520, the apparatus 100 for calculating the efficiency of the battery may acquire the weather forecast data. In one embodiment, the weather forecast data may include information about weather by time (e.g., temperature, rainfall, snowfall, or wind speed) and information on regional weather.

In operation 530, the apparatus 100 for calculating the efficiency of the battery may calculate the efficiency of the battery pack 103 of the electric vehicle 101.

In one embodiment, the apparatus 100 for calculating the efficiency of the battery may analyze the usage pattern of the electric vehicle 101 based on the usage data. In one embodiment, the apparatus 100 for calculating the efficiency of the battery may predict the next usage time and/or the next traveling route of the electric vehicle 101 based on the usage pattern.

In one embodiment, the apparatus 100 for calculating the efficiency of the battery may calculate the efficiency of the battery pack 103 of the electric vehicle 101 based on the weather forecast data. Here, the efficiency may represent a rate of change in available capacity that varies depending on temperature.

In one embodiment, the apparatus 100 for calculating the efficiency of the battery may calculate the efficiency of the battery pack 103 of the electric vehicle 101 based on the usage data and the weather forecast data. For example, the apparatus 100 for calculating the efficiency of the battery may calculate the efficiency of the battery pack 103 based on the next usage time and the weather forecast data. The apparatus 100 for calculating the efficiency of the battery may determine the temperature of the next usage time and calculate the efficiency of the battery pack 103 based on the determined temperature. For another example, the apparatus 100 for calculating the efficiency of the battery may determine the temperatures of the areas passing through along the next traveling route and calculate the efficiency of the battery pack 103 based on the determined temperature.

Thereafter, the apparatus 100 for calculating the efficiency of the battery may calculate the distance to empty and/or the travelable time of the electric vehicle 101 based on the efficiency.

## Claims

1. An apparatus (100) for calculating efficiency of a battery of an electric vehicle (101), comprising:
a data collection unit (110) configured to collect usage data on an electric vehicle (101);
a weather data acquisition unit (120) configured to acquire weather forecast data from an external server (105); and
a calculation unit (160) configured to calculate efficiency of the battery of the electric vehicle (101) based on the usage data and the weather forecast data,
**characterized in that**
the calculation unit (160) determines a relationship expression based on a battery efficiency database for the battery and calculates the efficiency of the battery based on the relationship expression, said database comprising information about numbers of capacity-discharge times and corresponding state of health, SoH, of the battery.

2. The apparatus (100) according to claim 1, further comprising: a pattern analysis unit (130) configured to analyze a usage pattern of the electric vehicle (101) based on the usage data; and
a prediction unit (140) configured to predict a next usage time of the electric vehicle (101) based on the usage pattern,
wherein the calculation unit (160) calculates the efficiency of the battery based on the next usage time and the weather forecast data.

3. The apparatus (100) according to claim 2, wherein the prediction unit (140) predicts a next traveling route of the electric vehicle (101) based on the usage pattern, and
the calculation unit (160) calculates the efficiency of the battery further based on the traveling route.

4. The apparatus (100) according to claim 1, further comprising a display unit (170) configured to display the calculated efficiency.

5. The apparatus (100) according to claim 1, wherein the relationship expression is a polynomial function with the highest order of 2 for a temperature.

6. The apparatus (100) according to claim 1, wherein the calculation unit (160) calculates the efficiency of the battery using the relationship expression in a predetermined temperature range.

7. The apparatus (100) according to claim 1, wherein the calculation unit (160) determines the relationship expression based on a state of health (SoH) of the battery.

8. The apparatus (100) according to claim 1, wherein the calculation unit (160) calculates a distance to empty of the electric vehicle (101) based on a SoH of the battery and the efficiency of the battery.

9. The apparatus (100) according to claim 1, further comprising a discharge rate analysis unit (150) configured to analyze a discharge rate of the battery of the electric vehicle (101) based on the usage data,
wherein the calculation unit (160) calculates a travelable time of the electric vehicle (101) based on the discharge rate and the efficiency of the battery.

10. A method of operating an apparatus (100) of calculating the efficiency of a battery, comprising:
an operation of collecting usage data on an electric vehicle (101);
an operation of acquiring weather forecast data from an external server (105); and
an operation of calculating efficiency of a battery of the electric vehicle (101) based on the usage data and the weather forecast data,
**characterized in that** the operation of calculating the efficiency of the battery includes:
an operation of determining a relationship expression based on a battery efficiency database for the battery; and
an operation of calculating the efficiency of the battery based on the relationship expression,
wherein the relationship expression is determined based on a battery efficiency database for the battery and the efficiency of the battery is calculated based on the relationship expression, said database comprising information about numbers of capacity-discharge times and corresponding state of health, SoH, of the battery.

11. The method according to claim 10, further comprising: an operation of analyzing a usage pattern of the electric vehicle (101) based on the usage data; and
an operation of predicting a next usage time of the electric vehicle (101) based on the usage pattern,
wherein the operation of calculating the efficiency of the battery includes an operation of calculating the efficiency of the battery based on the next usage time and the weather forecast data.

12. The method according to claim 11, further comprising an operation of predicting a next traveling route of the electric vehicle (101) based on the usage pattern,
wherein the operation of calculating the efficiency of the battery includes calculating the efficiency of the battery further based on the traveling route.

13. The method according to claim 10, further comprising an operation of displaying the calculated efficiency.

## Patentansprüche

1. Vorrichtung (100) zum Berechnen der Effizienz einer Batterie eines Elektrofahrzeugs (101), umfassend:
eine Datensammeleinheit (110), die konfiguriert ist, um Nutzungsdaten über ein Elektrofahrzeug (101) zu sammeln;
eine Wetterdatenerfassungseinheit (120), die konfiguriert ist, um Wettervorhersagedaten von einem externen Server (105) zu erfassen; und
eine Berechnungseinheit (160), die konfiguriert ist, um die Effizienz der Batterie des Elektrofahrzeugs (101) basierend auf den Nutzungsdaten und den Wettervorhersagedaten zu berechnen,
**dadurch gekennzeichnet, dass** die Berechnungseinheit (160) einen Beziehungsausdruck basierend auf einer Batterieeffizienzdatenbank für die Batterie bestimmt und die Effizienz der Batterie basierend auf dem Beziehungsausdruck berechnet, wobei die Datenbank Informationen über die Anzahl der Kapazität-Entlade-Zeiten und den entsprechenden Gesundheitszustand, SoH, der Batterie umfasst.

2. Vorrichtung (100) nach Anspruch 1, ferner umfassend: eine Musteranalyseeinheit (130), die konfiguriert ist, um ein Nutzungsmuster des Elektrofahrzeugs (101) basierend auf den Nutzungsdaten zu analysieren; und
eine Vorhersageeinheit (140), die konfiguriert ist, um eine nächste Nutzungszeit des Elektrofahrzeugs (101) basierend auf dem Nutzungsmuster vorherzusagen,
wobei die Berechnungseinheit (160) die Effizienz der Batterie basierend auf der nächsten Nutzungszeit und den Wettervorhersagedaten berechnet.

3. Vorrichtung (100) nach Anspruch 2, wobei die Vorhersageeinheit (140) eine nächste Fahrtroute des Elektrofahrzeugs (101) basierend auf dem Nutzungsmuster vorhersagt, und
die Berechnungseinheit (160) die Effizienz der Batterie ferner basierend auf der Fahrtroute berechnet.

4. Vorrichtung (100) nach Anspruch 1, ferner umfassend eine Anzeigeeinheit (170), die konfiguriert ist, um die berechnete Effizienz anzuzeigen.

5. Vorrichtung (100) nach Anspruch 1, wobei der Beziehungsausdruck eine Polynomfunktion mit der höchsten Ordnung von 2 für eine Temperatur ist.

6. Vorrichtung (100) nach Anspruch 1, wobei die Berechnungseinheit (160) die Effizienz der Batterie unter Verwendung des Beziehungsausdrucks in einem vorbestimmten Temperaturbereich berechnet.

7. Vorrichtung (100) nach Anspruch 1, wobei die Berechnungseinheit (160) den Beziehungsausdruck basierend auf einem Gesundheitszustand (SoH) der Batterie bestimmt.

8. Vorrichtung (100) nach Anspruch 1, wobei die Berechnungseinheit (160) einen Abstand zum Leeren des Elektrofahrzeugs (101) basierend auf einem SoH der Batterie und der Effizienz der Batterie berechnet.

9. Vorrichtung (100) nach Anspruch 1, ferner umfassend eine Entladeratenanalyseeinheit (150), die konfiguriert ist, um eine Entladerate der Batterie des Elektrofahrzeugs (101) basierend auf den Nutzungsdaten zu analysieren,
wobei die Berechnungseinheit (160) eine fahrbare Zeit des Elektrofahrzeugs (101) basierend auf der Entladerate und der Effizienz der Batterie berechnet.

10. Verfahren zum Betreiben einer Vorrichtung (100) zum Berechnen der Effizienz einer Batterie, umfassend:
einen Vorgang des Sammelns von Nutzungsdaten über ein Elektrofahrzeug (101);
einen Vorgang des Erfassens von Wettervorhersagedaten von einem externen Server (105); und
einen Vorgang des Berechnens der Effizienz einer Batterie des Elektrofahrzeugs (101) basierend auf den Nutzungsdaten und den Wettervorhersagedaten.

11. Verfahren nach Anspruch 10, ferner umfassend: einen Vorgang des Analysierens eines Nutzungsmusters des Elektrofahrzeugs (101) basierend auf den Nutzungsdaten; und
einen Vorgang des Vorhersagens einer nächsten Nutzungszeit des Elektrofahrzeugs (101) basierend auf dem Nutzungsmuster,
wobei der Vorgang des Berechnens der Effizienz der Batterie einen Vorgang des Berechnens der Effizienz der Batterie basierend auf der nächsten Nutzungszeit und den Wettervorhersagedaten einschließt,
**dadurch gekennzeichnet, dass** der Vorgang des Berechnens der Effizienz der Batterie einschließt:
einen Vorgang des Bestimmens eines Beziehungsausdrucks basierend auf einer Batterieeffizienzdatenbank für die Batterie; und
einen Vorgang des Berechnens der Effizienz der Batterie basierend auf dem Beziehungsausdruck,
wobei der Beziehungsausdruck basierend auf einer Batterieeffizienzdatenbank für die Batterie bestimmt wird und die Effizienz der Batterie basierend auf dem Beziehungsausdruck berechnet wird, wobei die Datenbank Informationen über die Anzahl der Kapazität-Entlade-Zeiten und den entsprechenden Gesundheitszustand, SoH, der Batterie umfasst.

12. Verfahren nach Anspruch 11, ferner umfassend einen Vorgang des Vorhersagens einer nächsten Fahrtroute des Elektrofahrzeugs (101) basierend auf dem Nutzungsmuster,
wobei der Vorgang des Berechnens der Effizienz der Batterie das Berechnen der Effizienz der Batterie ferner basierend auf der Fahrtroute einschließt.

13. Verfahren nach Anspruch 10, ferner umfassend einen Vorgang des Anzeigens der berechneten Effizienz.

## Revendications

1. Appareil (100) pour calculer le rendement d'une batterie d'un véhicule électrique (101), comprenant :
une unité de collecte de données (110) configurée pour collecter des données d'utilisation sur un véhicule électrique (101) ;
une unité d'acquisition de données météorologiques (120) configurée pour acquérir, d'un serveur externe (105), des données de prévision météo ; et
une unité de calcul (160) configurée pour calculer le rendement de la batterie du véhicule électrique (101) d'après les données sur l'utilisation et les données de prévisions météorologiques,
**caractérisé en ce que** l'unité de calcul (160) détermine une expression de relation basée sur une base de données sur le rendement des batteries pour la batterie, et calcule le rendement de la batterie d'après l'expression de relation, ladite base de données comprenant des informations sur les nombres de temps de capacité-décharge et l'état de santé, SoH, correspondant de la batterie.

2. Appareil (100) selon la revendication 1, comprenant en outre : un module d'analyse de modèle (130) configuré pour analyser un modèle d'utilisation du véhicule électrique (101) d'après les données d'utilisation ; et
un module de prédiction (140) configuré pour prédire un temps d'utilisation prochain du véhicule électrique (101) d'après le modèle d'utilisation,
l'unité de calcul (160) calculant le rendement de la batterie en fonction du temps d'utilisation suivant et des données de prévision météo.

3. Appareil (100) selon la revendication 2, le module de prédiction (140) prévoyant un prochain itinéraire du véhicule électrique (101) en fonction du modèle d'utilisation, et
l'unité de calcul (160) calculant en outre le rendement de la batterie en fonction de l'itinéraire.

4. Appareil (100) selon la revendication 1, comprenant en outre un dispositif d'affichage (170) configuré pour afficher le rendement calculé.

5. Appareil (100) selon la revendication 1, l'expression de relation étant est une fonction polynomiale de l'ordre le plus élevé de 2 pour une température.

6. Appareil (100) selon la revendication 1, l'unité de calcul (160) calculant le rendement de la batterie en utilisant l'expression de relation dans une plage de température prédéterminée.

7. Appareil (100) selon la revendication 1, l'unité de calcul (160) déterminant l'expression de relation en fonction de l'état de santé (SoH) de la batterie.

8. Appareil (100) selon la revendication 1, l'unité de calcul (160) calculant une distance d'autonomie restante pour le véhicule électrique (101) en fonction d'un SoH de la batterie et du rendement de la batterie.

9. Appareil (100) selon la revendication 1, comprenant en outre : un module d'analyse de la vitesse de décharge (150) configuré pour analyser un taux de décharge de la batterie du véhicule électrique (101) d'après les données d'utilisation,
l'unité de calcul (160) calculant un temps circulable du véhicule électrique (101) d'après le taux de décharge et le rendement de la batterie.

10. Procédé d'utilisation d'un appareil (100) de calcul du rendement d'une batterie, comprenant :
une opération de collecte de données d'utilisation sur un véhicule électrique (101) ;
une opération d'acquisition, d'un serveur externe (105), de données de prévision météo ; et
une opération de calcul du rendement d'une batterie du véhicule électrique (101) d'après les données d'utilisation et les données de prévision météo,
**caractérisé en ce que** l'opération de calcul du rendement de la batterie comprend :
une opération de détermination d'une expression de relation d'après une base de données sur le rendement des batteries pour la batterie ; et
une opération de calcul du rendement de la batterie d'après l'expression de relation,
l'expression de relation étant déterminée d'après une base de données sur le rendement des batteries pour la batterie, et le rendement de la batterie étant calculé d'après l'expression de relation, ladite base de données comprenant des informations sur les nombres de temps de capacité-décharge et l'état de santé, SoH, correspondant de la batterie.

11. Procédé selon la revendication 10, comprenant en outre : une opération d'analyse du modèle d'utilisation du véhicule électrique (101) d'après les données sur l'utilisation ; et
une opération de prédiction d'un temps d'utilisation suivant du véhicule électrique (101) d'après le modèle d'utilisation,
l'opération du calcul du rendement de la batterie comprenant une opération de calcul du rendement de la batterie en fonction du temps d'utilisation suivant et des données météo.

12. Procédé selon la revendication 11, comprenant en outre une opération de prédiction d'un itinéraire suivant du véhicule électrique (101) d'après le modèle d'utilisation,
l'opération du calcul du rendement de la batterie comprenant le calcul du rendement de la batterie basé en outre sur l'itinéraire.

13. Procédé selon la revendication 10, comprenant en outre une opération d'affichage du rendement calculé.
